# EUROPEAN PATENT APPLICATION

(11) **EP 2 226 684 A1**
(43) Date of publication of application: **08.09.2010**
(21) Application number: 08859266.2
(22) Date of filing: 12.12.2008
(51) Int. Cl.: G03F 7/34, B41C 1/055, G03F 7/00, G03F 7/033, G03F 7/36

(54) **PROCESS FOR PRODUCING REGENERATED POROUS SHEET**

(30) Priority: 13.12.2007 JP 2007322325
(71) Applicant: Asahi Kasei E-materials Corporation, Tokyo 101-8101 (JP)
(72) Inventor: YAMADA, Hiroshi, Tokyo 101-8101 (JP); MORI, Masahiro, Tokyo 101-8101 (JP)
(74) Representative: Strehl Schübel-Hopf & Partner
(86) International application number: PCT/JP2008/072704
(87) International publication number: WO 2009/075364

(57) **Abstract**

The present invention provides a method for producing a regenerated porous sheet including a step of bringing a porous sheet which has adsorbed an uncured part of a photosensitive resin, into contact with a solvent to separate the uncured part from.the porous sheet, the porous sheet that has adsorbed the uncured part being produced by curing a specific area of a printing surface of a printing original plate in which the printing surface is formed from a photosensitive resin, and then absorbing the uncured part of the printing surface into a porous sheet, so as to conduct a development.

## Description

### Technical Field

The present invention relates to a method for producing a regenerated porous sheet, the regenerated porous sheet, a method for producing a printing plate, a system which regenerates a porous sheet, a method for recycling the porous sheet and an uncured-part separation apparatus.
Specifically, the present invention relates to a technology for separating a photosensitive resin which has been adsorbed by the porous sheet that is used in development treatment in photoengraving technology for producing a photosensitive-resin relief printing plate, so as to regenerate the porous sheet.

### Background Art

In recent years, thermal development has been gradually used in a photoengraving technology when a photosensitive-resin relief printing plate is produced which is used in the fields of a flexography, a dry-offset printing, an embossing process and the like. In a conventional photoengraving technology, a photosensitive-resin relief printing plate has been produced through an exposure step of irradiating a photosensitive resin with light through an exposure mask, and a development step of dissolving or dispersing an uncured portion which has not been irradiated with light, in a solvent or a cleaning liquid.
Patent document 1 discloses a thermal development process of melting an uncured part by heating, and making the melted part adsorbed by a sheet-shaped adsorption layer (porous sheet) of a non-woven fabric or the like to remove the uncured part.
Patent Document 1 Japanese Patent Application Laid-Open No. 5-19469

### Disclosure of the Invention

### Problems to be Solved by the Invention

However, when a photosensitive-resin relief printing plate is produced, a depth of the relief needs to be approximately 0.3 mm to 2 mm, and accordingly, when a thermal development process is adopted, it is necessary for removing the uncured part to bring the uncured part into contact with a new non-woven fabric on several divided times or occasionally over several tens of times and make the non-woven fabric adsorb the melted photosensitive resin composition part. The used non-woven fabric which has been produced in this thermal development treatment adsorbs the photosensitive resin therein. Thus, the used non-woven fabric contains a large amount of the photosensitive resin therein, and accordingly is disposed in large quantities as an industrial waste. Then, the influence of the disposal on the global environment is a concern.
Patent document 1 discloses a method of regenerating a photosensitive material itself in the form of a regenerated pellet by using a heated air or a pressed air, but does not disclose a method of regenerating a sheet-shaped adsorption layer.
In addition, according to the method in Patent document 1, the photosensitive material itself which has been adsorbed in the sheet-shaped adsorption layer is denatured by the heat of the heated air, and is more strongly adsorbed by the sheet-shaped adsorption layer, so it is difficult to regenerate such a development sheet capable of being used again in thermal development.

An object to be achieved by the present invention is to provide a technology for separating the photosensitive resin from a porous sheet which contains the photosensitive resin and is produced in large quantities in the thermal development treatment to be carried out, for instance, when a photosensitive-resin relief printing plate is produced by using a photoengraving technology, and of regenerating even the porous sheet as well.

### Means for Solving the Problems

As a result of having made an extensive investigation, the present inventors have found that a used porous sheet (porous sheet which has been produced in thermal development treatment and contains photosensitive resin) can be regenerated into such a degree as to be capable of being recycled, by specific steps, and that an environmentally friendly regenerating system can be attained by using such a regenerated porous sheet and the like, and completed the present invention.

Specifically, the present invention comprises the following:
[1] A method for producing a regenerated porous sheet comprising
   a step of bringing a porous sheet which has adsorbed an uncured part of a photosensitive resin, into contact with a solvent to separate the uncured part from the porous sheet,
   the porous sheet that has adsorbed uncured part being produced by curing a specific area of a printing surface of a printing original plate in which the printing surface is formed from the photosensitive resin, and then absorbing the uncured part of the printing plate into a porous sheet, so as to conduct a development.
[2] The method according to item [1], wherein the developing is thermal development.
[3] The method according to item [1] or [2], wherein the step of bringing of the porous sheet into contact with the solvent is performed in a way that the solvent is passed from one surface side of the porous sheet to the other surface side through the inner part of the porous sheet.
[4] The method according to any one of items [1] to [3], wherein the step of bringing of the porous sheet into contact with the solvent is performed in a way that the porous sheet is wound into the form of a roll.
[5] The method according to item [4], wherein the porous sheet is in a form of being wound into the form of a roll of multilayer structure.
[6] The method according to any one of items [1] to [5], wherein the melting temperature of the photosensitive resin is 80°C or more and 200°C or less, and the photosensitive resin is solid at a temperature of 20°C.
[7] The method according to any one of items [1] to [6], wherein the photosensitive resin contains a thermoplastic elastomer which has a number average molecular weight of 50,000 or more and 500,000 or less, and an organic compound which has a number average molecular weight of less than 50,000 and has a polymerizable unsaturated group in the molecule.
[8] The method according to item [6] or [7], wherein the thermoplastic elastomer is a styrenic elastomer.
[9] The method according to any one of items [1] to [8], wherein the solvent comprises at least one selected from the group consisting of an aromatic hydrocarbon, an alicyclic hydrocarbon, a straight-chain hydrocarbon, a branched hydrocarbon and a halogenated hydrocarbon.
[10] The method according to any one of items [1] to [9], wherein the solvent comprises a supercritical fluid.
[11] The method according to item [10], wherein the supercritical fluid is supercritical carbon dioxide.
[12] The method according to item [10] or [11], wherein a critical point of the supercritical fluid exists in a temperature range of 25°C or more and 80°C or less and in a pressure range of 3 MPa or more and 100 MPa or less.
[13] The method according to any one of items [1] to [12], wherein the porous sheet is comprised of a fibrous material.
[14] The method according to any one of items [1] to [13], wherein the porous sheet comprises at least one selected from the group consisting of polyester, polyolefin, polyurethane, polyamide and cellulose, as a main component.
[15] The method according to any one of items [1] to [14], wherein the porous sheet is a woven fabric or a non-woven fabric.
[16] A regenerated porous sheet obtained by the method according to any one of items [1] to [15].
[17] A method for producing a printing plate in which a printing surface is formed from a photosensitive resin, comprising a step of developing with a use of the regenerated porous sheet according to item [16].
[18] A system for regenerating a porous sheet, comprising:
   an exposure apparatus which cures a specific area of a printing surface of a printing original plate in which the printing surface is formed from a photosensitive resin;
   a development apparatus which absorbs an uncured part of the printing surface of the printing original plate into a porous sheet, so as to conduct a development; and
   an uncured-part separation apparatus which brings the porous sheet which has adsorbed the uncured part, into contact with a solvent to separate the uncured part from the porous sheet, thereby producing a solution of the separated uncured part and a regenerated porous sheet.
[19] The system according to item [18], wherein the regenerated porous sheet is used in the development apparatus.
[20] The system according to item [18] or [19], further comprising a solvent separation apparatus which separates a solvent from the solution of the separated uncured part to produce the separated uncured part and a separated solvent.
[21] The system according to item [20], wherein the separated solvent is used in the uncured-part separation apparatus.
[22] The system according to item [20] or [21], further comprising a printing-original-plate forming apparatus which forms the printing original plate while using a photosensitive resin containing the separated uncured part.
[23] A method for recycling a porous sheet, comprising:
   (A) a step of bringing a porous sheet which has adsorbed an uncured part of a photosensitive resin, into contact with a solvent to separate the uncured part from the porous sheet, thereby producing a solution of the separated uncured part and a regenerated porous sheet; and
   (B) a step of absorbing the uncured part of a printing surface into a porous sheet while using the regenerated porous sheet, after the step (A),
      the porous sheet that has adsorbed the uncured part being produced by curing a specific area of a printing surface of a printing original plate in which the printing surface is formed from the photosensitive resin, and then absorbing the uncured part of the printing plate into a porous sheet, so as to conduct a development.
[24] The method according to item [23], further comprising (C) a step of separating the solvent from the solution of the separated uncured part to produce the separated uncured part and a separated solvent.
[25] The method according to item [24], further comprising (D) a step of bringing the porous sheet which has adsorbed the uncured part, into contact with the solvent while using the separated solvent as the solvent.
[26] The method according to item [24] or [25], further comprising (E) a step of forming the printing original plate while using the photosensitive resin containing the separated uncured part.
[27] An uncured-part separation apparatus which brings a porous sheet which has adsorbed an uncured part of a photosensitive resin, into contact with a solvent to separate the uncured part from the porous sheet, comprising:
   a cleaning tank for separating the uncured part from the porous sheet;
   a stirring shaft which is arranged in the cleaning tank, and which holds the porous sheet in a way that the porous sheet is wound, and is rotatable in a circumferential direction thereof; and
   a line which supplies the solvent and a line which discharges a solution of a separated uncured part, which contains the separated uncured part that has been separated from the porous sheet,
   the porous sheet that has adsorbed the uncured part being produced by curing a specific area of a printing surface of a printing original plate in which the printing surface is formed from a photosensitive resin, and then absorbing the uncured part of the printing surface into a porous sheet, so as to conduct a development.

### Advantages of the Invention

According to the present invention, a porous sheet containing a photosensitive resin can be regenerated by separating the photosensitive resin from the porous sheet.

### Brief Description of the Drawings

Figure 1 illustrates a schematic view of a regenerating system;
Figure 2 illustrates a schematic view of a regenerating system; and
Figure 3 illustrates a schematic view of a regenerating system.

### Description of Symbols

- 1:: High-pressure chamber
- 2:: Heater
- 3:: High-pressure pump
- 4:: Cooler
- 5:: Separation tank
- 6:: Expansion valve
- 7:: Porous sheet wound in roll form
- 8:: Metallic cylinder
- 9:: Cleaning tank
- 10:: Hydrocarbon-based solvent tank
- 11:: Pump
- 12:: Stirring shaft
- 13:: Heating and cooling tank
- 14:: Valve
- 15:: Carbon dioxide tank

### Best Mode for Carrying Out the Invention

The best mode for carrying out the present invention (hereinafter referred to as "present embodiment") will be described in detail below. However, the present invention is not limited to the following embodiments, but various changes can be made within a range of the scope.

### [Method for producing regenerated porous sheet and method for producing printing plate]

A method for producing a regenerated porous sheet according to the present embodiment is a method of producing the regenerated porous sheet from a porous sheet that is produced by curing a specific area of a printing surface of a printing original plate in which the printing surface is formed from a photosensitive resin, and then absorbing the uncured part of the printing surface into a porous sheet which has adsorbed the uncured part, so as to conduct a development.
The method for producing the regenerated porous sheet according to the present embodiment is a method of producing the regenerated porous sheet, which includes a step of bringing a resin sheet which has adsorbed an uncured part of a printing surface, into contact with a solvent to separate the uncured part from the porous sheet, in order to produce the regenerated porous sheet.
The step of bringing the resin sheet which has adsorbed the uncured part into contact with the solvent to separate the uncured part from the porous sheet is hereafter occasionally abbreviated to "uncured-part separation step".
The method for producing a printing plate according to the present embodiment is a method of producing the printing plate, which includes a development step with the use of the regenerated porous sheet obtained by the method of producing the regenerated porous sheet.

In the method for producing the printing plate according to the present embodiment, other steps are not limited in particular, as long as the method includes the development step with the use of the regenerated porous sheet, and the printing plate can be produced through a process which is employed when a printing plate is generally produced.
The printing plate according to the present embodiment can be produced by various methods.
The method includes, for instance, steps of dissolving a photosensitive resin in an adequate solvent, for instance, chloroform, tetrachloroethylene, methyl ethyl ketone and toluene, mixing the mixture and casting the solution into a mold. By evaporating the solvent, a plate-shaped printing original plate can be formed in the state. When producing the printing original plate, it is also preferable to knead a photosensitive resin with a kneader, a roll mill or a screw extruder without using the above described solvent, and mold the photosensitive resin with a calender roll, a press and the like, so as to acquire a desired thickness.
The photosensitive resin is usually sticky. Accordingly, in order to enhance the easiness of contact with a negative film to be overlapped thereon in a plate-making process or to enable the negative film to be reused, it is also preferable to provide a thin and flexible protective layer which is soluble in a solvent (see Japanese Patent Application Laid-Open No. S61-211420, for instance) on the printing surface. It is also preferable to form the protective layer as a UV-shielding layer containing an infrared-susceptible substance, and to use the protective layer itself as a negative film after having directly drawn an image thereon with the use of an infrared laser.
When an unexposed part is washed out after the printing plate has been exposed to light, any of the above described thin flexible protective layers is also simultaneously removed.

When a layer of polyamide, partially-saponified polyvinyl acetate or cellulose ester, for instance, which is soluble in a developing solution, is provided on the surface of the photosensitive resin layer as a thin and flexible protective layer that is soluble in a solvent, it is also preferable to dissolve the compound in an adequate solvent and to apply the solution directly onto the printing surface of the printing original plate. Alternatively, it is also preferable to apply the solution (to form protective film) on a film made from polyester, polypropylene and the like, and then to laminate or compression-bond and transfer the protective film onto the printing surface.
It is possible to produce a printing face which is formed from a photosensitive resin and has a higher thickness precision, by forming a sheet of a photosensitive resin, bringing the protective film or a support into close contact with a photosensitive resin composition with a roll laminate technique to laminate them, and then heating and pressing the laminate.
A flexographic printing plate is produced from a photosensitive resin for a flexographic printing plate generally by the steps of: subjecting the whole support-side surface to UV-exposure (back exposure) through the support to form a thin and uniform cured layer on the whole support-side surface; then subjecting the printing surface which is formed from the photosensitive resin, to an image exposure (relief exposure) through a negative film or directly from the top of the UV-shielding layer; subsequently washing out the unexposed part of the printing surface with a solvent for development; and subjecting the printing plate to a post-treatment exposure.
Any of the exposure (relief exposure) from the negative film side or the exposure (back exposure) from the support side may be precedently carried out, or both exposures may be simultaneously carried out.
Examples of usable light sources for exposure may include a high-pressure mercury lamp, an ultraviolet fluorescent lamp, a carbon-arc lamp and a xenon lamp.

In the present embodiment, a method of absorbing an uncured part of a printing surface into a porous sheet or a regenerated porous sheet, so as to conduct a development includes, for instance, a solvent development method of swelling the uncured part of a photosensitive resin with the use of a solvent or the like and making the porous sheet adsorb the swelled photosensitive resin, and a thermal development process of heating and melting the uncured part of the photosensitive resin and making the porous sheet adsorb the melted photosensitive resin.
Treatment carried out in the thermal development process generally includes melting the photosensitive resin in the uncured part which has been light-shielded by an exposure mask by heating, and making the porous sheet adsorb and remove the melted photosensitive resin. In the porous sheet which has adsorbed the uncured part, the uncured part may be "absorbed" even into the inner part of the porous sheet.
In the present embodiment, the concept of "adsorption" includes the concept of "absorption."

In the present embodiment, the solvent is not limited in particular, and includes a solvent which can dissolve or disperse the photosensitive resin therein.
The solvent includes, for instance, an aromatic hydrocarbon, an alicyclic hydrocarbon and a halogenated hydrocarbon which are used in solvent development treatment when a photosensitive-resin relief printing plate is produced. The solvents of the aromatic hydrocarbon, the alicyclic hydrocarbon, a straight-chain hydrocarbon, a branched hydrocarbon and the halogenated hydrocarbon may be used solely or in the form of a mixture solvent containing two or more solvents.
In the present embodiment, the solvent preferably has easily vaporizable characteristics from the viewpoint that the solvent needs to be easily evaporated and separated from a solution containing an uncured part of the photosensitive resin after an uncured-part separation step.
In addition, a diluting solvent which is arbitrarily used for a photosensitive resin when a printing surface is formed from a photosensitive resin preferably has the same composition as a solvent which is brought into contact with a porous sheet which has adsorbed the uncured part.
The evaporated solvent can be used again as a solvent to be used in a solvent contact step.

Examples of the aromatic hydrocarbon may include toluene, xylene, benzene, ethylbenzene and propylbenzene.
Examples of the alicyclic hydrocarbon may include cyclohexane, cyclopentane and cyclooctane.
Examples of the halogenated hydrocarbon may include dichloromethane, chloroform, tetrachloromethane and tetrachloroethylene.
Examples of the straight-chain hydrocarbon may include n-hexane, n-heptane and n-octane.
Examples of the branched hydrocarbon may include 2-methylhexane, 2-ethylhexane, 3-methylhexane and 3-ethylhexane.
The solvent is preferably toluene or cyclohexane, and more preferably is toluene, from the viewpoint of its solubility and the reusability of the solvent.

In the present embodiment, the solvent includes a supercritical fluid.
In the present embodiment, "supercritical fluid" means a fluid in a region beyond a critical temperature which is a temperature of a critical point existing on a boundary line in a temperature-pressure state of a substance and a critical pressure which is a pressure of the critical point.
The supercritical fluid is a fluid with a high pressure or a fluid with a high temperature and a high pressure, and is a fluid having both of liquid characteristics and gaseous characteristics.
The density of the supercritical fluid is equivalent to one-fifth of the density shown when the supercritical fluid is liquid to the same density of the liquid, and is several hundreds times larger than the density shown when the supercritical fluid is a gas.
The viscosity of the supercritical fluid is equivalent to that of the gas, and a diffusion coefficient of the supercritical fluid is middle between the gas and the liquid.
A substance which forms the supercritical fluid has a specific critical point. For instance, the critical temperature of carbon dioxide is 31.1°C and the critical pressure is 7.4 MPa; the critical temperature of water is 374.2°C and the critical pressure is 22.1 MPa; the critical temperature of methanol is 239.4°C and the critical pressure is 8.1 MPa; the critical temperature of ethanol is 243°C and the critical pressure is 6.4 MPa; and the critical temperature of 1-propanol is 263.5°C and the critical pressure is 5.2 MPa. The supercritical fluid has characteristics of dissolving an organic substance therein and having high penetrability.

The critical point of the supercritical fluid exists preferably in a region of a temperature of 25°C or more and 80°C or less, and of a pressure of 3 MPa or more and 100 MPa or less. When the critical point of the supercritical fluid exists in the above described range, the supercritical fluid is extremely easy to be handled, and gives little damage to a component contained in an uncured part to be treated by the supercritical fluid because the critical point is comparatively low. The substance which forms the supercritical fluid includes carbon dioxide, sulfur hexafluoride (having critical temperature of 45°C and critical pressure of 3.75 MPa), and pentafluoroethane (having critical temperature of 66°C and critical pressure of 3.62 MPa). A usable substance which forms the supercritical fluid is preferably carbon dioxide, from the viewpoint of being easily handled. When the carbon dioxide is used, it is used preferably at a temperature of 31.1°C or more and 100°C or less and a pressure of 7.4 MPa or more and 50 MPa or less, and more preferably in a range of a temperature of 35°C to 60°C and a pressure of 10 MPa to 30 MPa. The concentration of the carbon dioxide contained in the supercritical fluid is preferably 50% by volume or more, is more preferably 70% by volume or more, and may be 100% by volume.

The solvent according to the present embodiment includes at least one compound selected from the group consisting of an aromatic hydrocarbon, an alicyclic hydrocarbon, a straight-chain hydrocarbon, a branched hydrocarbon, a halogenated hydrocarbon and a supercritical fluid.
These solvents may be used solely or in the form of a mixture solvent containing two or more solvents.
In the present embodiment, it is preferable to use a mixture solvent prepared by adding the above described hydrocarbon-based solvent to the supercritical fluid, from the viewpoint of enhancing the solubility of a photosensitive resin.
When carbon dioxide is used as the supercritical fluid, it is preferable to enhance the dissolving power by adding the hydrocarbon-based solvent to the carbon dioxide.
The hydrocarbon-based solvent to be added to the supercritical fluid preferably includes toluene, xylene, benzene, dichloromethane and tetrachloroethylene, which can adequately dissolve the photosensitive resin therein at room temperature.
The content of the hydrocarbon-based solvent in the mixture solvent is preferably 1 mass% or more based on the whole amount of the solvent, and is more preferably 5 mass% or more.

In the present embodiment, a porous sheet is not limited in particular, and includes a porous sheet which can adsorb an uncured part of the photosensitive resin.
The porous sheet is preferably constituted by a fibrous material, from the viewpoint of more adequately adsorbing the photosensitive resin.
The form of the porous sheet includes, for instance, a woven fabric, a non-woven fabric, a silk cloth, and a foam such as a sponge.
The form of the porous sheet is preferably the woven fabric or the non-woven fabric, from the viewpoint of being dimensionally stable and being easily handled.

A density of the porous sheet is preferably 0.1 g/cm³ or more and 0.8 g/cm³ or less, more preferably is 0.3 g/cm³ or more and 0.7 g/cm³ or less, and further preferably is 0.4 g/cm³ or more and 0.7 g/cm³ or less, from the viewpoint of efficiently removing the resin of the uncured part.
In the present embodiment, the density of the porous sheet is a value determined by measuring the weight and the thickness per unit area of the porous sheet based on JIS-L-1096, and calculating these values.

The material of the porous sheet preferably includes at least one material selected from among polyesters such as polyethylene terephthalate and polyethylene naphthalate; polyolefins such as polypropylene and polyethylene; polyurethane; polyamides such as nylon 6 and nylon 6,6; and cellulose, as a main component, from the viewpoint of being resistant to multiple uses.
The "main component" in the present embodiment means that the specific component occupies 50 mass% or more of the material by a ratio.
In the present embodiment, the ratio of the specific component as the main component occupying in the material is preferably 70 mass% or more, and is more preferably 90 mass% or more.
The ratio of the specific component occupying in the material is also preferably 100 mass%.

In the present embodiment, the trapped photosensitive resin is removed by spouting a solvent to the porous sheet which has been wound into the form of a roll, from the inside, and at this time, a pressure is applied to the porous sheet. Accordingly, the material of the porous sheet is preferably a polyester, a polyolefin or a polyamide, from the viewpoint of being mechanically strong and dimensionally stable.

In the present embodiment, the photosensitive resin is not limited in particular, and includes, for instance, a photosensitive resin to be used in a filed of a photoengraving technology to be used when producing a photosensitive resin relief plate through an exposure step and a development step.
The photosensitive resin is preferably a solid photosensitive resin at 20°C, from the viewpoint of being easily handled.

The melting temperature of the photosensitive resin preferably exists in a range of 80°C or more and 200°C or less, from the viewpoint of being easily handled.
In the present embodiment, the "melting temperature" means a temperature at which the photosensitive resin can be molded, and is a temperature which can also be obtained by adding 30°C to a softening temperature of the thermoplastic elastomer.
The softening temperature of the thermoplastic elastomer means the first temperature at which a value of a storage modulus (E') greatly decreases (gradient of storage modulus curve changes) in the dynamic viscoelasticity measurement of raising the temperature of the photosensitive resin from room temperature.
In the present embodiment, the softening temperature is a value determined by measuring the storage modulus, while raising the temperature of the thermoplastic elastomer from room temperature at a constant speed with the use of an instrument for measuring dynamic viscoelasticity such as a rheometer.

The photosensitive resin preferably includes a thermoplastic elastomer which has a number average molecular weight of 50,000 or more and 500,000 or less, and an organic compound which has a number average molecular weight of less than 50,000 and has a polymerizable unsaturated group in the molecule, from the viewpoint of keeping moldability to be shown when a printing plate is produced and strength to be obtained when the printing plate has been produced.
The number average molecular weight of the thermoplastic elastomer is more preferably in a range of 100,000 or more and 300,000 or less, from the viewpoint of keeping the strength to be obtained when the printing plate has been produced.
The "number average molecular weight" in the present embodiment means a value obtained by measuring with gel permeation chromatography, calibrating the measured value with the value of polystyrene of which the molecular weight is known, and converting the measured value to the number average molecular weight.

The thermoplastic elastomer preferably has a polymerizable unsaturated group in the molecule, from the viewpoint that a cured substance of the photosensitive resin needs to have a mechanical strength.
The "polymerizable unsaturated group" in the present embodiment means a polymerizable functional group which is involved in radical polymerization, addition polymerization and condensation polymerization.

A polymer to be a skeleton of the thermoplastic elastomer can employ one or more compounds selected from the group consisting of polyolefins such as polyethylene and polypropylene; polydiens such as polybutadiene and polyisoprene; polyhalo-olefins such as polyvinyl chloride and polyvinylidene chloride; and polystyrene, polyacrylonitrile, polyvinyl alcohol, polyvinyl acetate, polyvinyl acetal, polyacrylic acid, poly(meta)acrylic ester, poly(meta)acrylamide, polyester, polycarbonate, polyacetal, polyurethane, polyamide, polyurea, polyimide and silicones.
When a plurality of monomers are used, the form of the copolymer may be a random copolymer, a block copolymer or the blend (mixture).
The thermoplastic elastomer is preferably a styrenic elastomer, from the viewpoint of suitability to the printing plate and solubility in a solvent, and more preferably is a thermoplastic elastomer such as styrene-butadiene-styrene (SBS), styrene-isoprene-styrene (SIS), styrene-butadiene (SB), styrene-ethylene / butylene-styrene (SEBS), and styrene-butadiene-isoprene-styrene (SBIS).

The "organic compound which has a number average molecular weight of less than 50,000 and has a polymerizable unsaturated group in the molecule" in the present embodiment refers to a compound which has a number average molecular weight of less than 50,000 and has a polymerizable unsaturated group.
The number average molecular weight of the organic compound is preferably less than 1,000, from the viewpoint of being easily compatible with the thermoplastic elastomer.
The organic compound includes, for instance: olefins such as ethylene, propylene, styrene and divinylbenzene; acetylenes; (meta)acrylic acid and a derivative thereof; haloolefins; unsaturated nitriles such as acrylonitrile; (meta)acrylamide and a derivative thereof; an unsaturated dicarboxylic acid such as maleic anhydride, maleic acid and fumaric acid, and a derivative thereof; vinyl acetates; N-vinylpyrrolidone; N-vinylcarbazole; and a compound having such an epoxy group or an oxetane group as to cause an addition polymerization reaction.
Among them, the organic compound is preferably (meta)acrylic acid or a derivative thereof, from the viewpoint of the abundant types, the price and the resolvability to be shown when the printing plate has been irradiated with a laser beam.

In the present embodiment, the above described "derivative" includes, for instance: an alicyclic compound which has a cycloalkyl group, a bicycloalkyl group, a cycloalkenyl group and a bicycloalkenyl group; an aromatic compound which has a benzyl group, a phenyl group, a phenoxy group, a naphthalene skeleton, an anthracene skeleton, a biphenyl skeleton, a phenanthrene skeleton and a fluorene skeleton; and a compound which has an alkyl group, an alkyl halide group, an alkoxyalkyl group, a hydroxyalkyl group, an aminoalkyl group, a glycidyl group and the like. In addition, the ester-based derivative includes an ester compound with a polyhydric alcohol such as alkylene glycol, polyoxyalkylene glycol, polyalkylene glycol and trimethylol propane.
The above described "derivative" includes a compound which has been denatured by a compound having a polysiloxane structure such as polydimethylsiloxane and polydiethylsiloxane, and a compound which has been denatured by a heteroaromatic compound containing an element such as nitrogen and sulfur.

In the present embodiment, a compound having such an epoxy group therein to cause an addition polymerization reaction includes a compound obtained by making a polyol such as various diols and triols react with epichlorohydrin, and an epoxy compound obtained by making a peroxy acid react with an ethylene bond in the molecule.
The compound having such an epoxy group therein to cause the addition polymerization reaction includes, for instance: an epoxy compound such as ethylene glycol diglycidyl ether, diethylene-glycol diglycidyl ether, triethylene glycol diglycidyl ether, tetraethylene glycol diglycidyl ether, polyethylene glycol diglycidyl ether, propylene glycol diglycidyl ether, tripropylene glycol diglycidyl ether, polypropylene glycol diglycidyl ether, neopentyl glycol diglycidyl ether, 1,6-hexanediol diglycidyl ether, glycerin diglycidyl ether, glycerin triglycidyl ether, trimethylolpropane triglycidyl ether, bisphenol A diglycidyl ether, hydrogenated bisphenol A diglycidyl ether, diglycidyl ether of a compound in which ethylene oxide or propylene oxide is added to bisphenol A, polytetramethylene glycol diglycidyl ether, poly(propylene glycol adipate)diol diglycidyl ether, poly(ethylene glycol adipate)diol diglycidyl ether and poly(caprolactone)diol diglycidyl ether; and an epoxy-modified silicone oil (product name "HF-105" made by Shin-Etsu Chemical Co., Ltd.).

In the present embodiment, one or more organic compounds can be selected from among these organic compounds according to the purpose.
The organic compound preferably contains at least one of the above described derivatives of a long-chain aliphatic, an alicyclic or an aromatic compound among the above compounds, from the viewpoint of reducing the swelling of the photosensitive resin due to an organic solvent such as an alcohol and an ester, which is a solvent for a printing ink.

As for a blending ratio of the thermoplastic elastomer and the organic compound in the photosensitive resin, the ratio of the organic compound is preferably in a range of 5 to 200 parts by mass based on 100 parts by mass of the thermoplastic elastomer, and more preferably is in a range of 20 to 100 parts by mass.
When the blending ratio of the organic compound is within the above described range, the hardness of a cured substance of the photosensitive resin to be obtained is easily balanced with the tensile strength and elongation. Then, the degree of shrinkage occurring in a photo-curing step is kept small, and the thickness precision of the printing original plate can be secured.

Photopolymerization initiators can be added to the photosensitive resin, which are a hydrogen-abstraction type photopolymerization initiator, a decaying type photopolymerization initiator, and/or a compound having a site which functions as the hydrogen-abstraction type photopolymerization initiator and a site which functions as the decaying type photopolymerization initiator, in the same molecule.

The hydrogen-abstraction type photopolymerization initiator in the present embodiment is not limited in particular, but is preferably an aromatic ketone.
In regard to the chemical reaction mechanism of the aromatic ketone functioning as the photopolymerization initiator, such a chemical reaction mechanism is proposed that an excitation triplet state is efficiently caused by photoexcitation and extracts hydrogen from a medium in the periphery to produce a radical.
According to the chemical reaction mechanism, it is considered that the radical produced by the aromatic ketone which has been optically excited is involved in a photo-crosslinking reaction.
The aromatic ketone includes benzophenones, Michler's ketones, xanthenes, thioxanthones and anthraquinones.
At least one compound selected from the aromatic ketone is preferably used as the hydrogen-abstraction type photopolymerization initiator.
The benzophenones mean benzophenone and a derivative thereof, and include, for instance, 3,3',4,4'-benzophenonetetracarboxylic acid anhydride and 3,3',4,4'-tetramethoxybenzophenone.

The Michler's ketones mean Michler's ketone and a derivative thereof.
The xanthenes mean xanthene and a derivative in which a part of xanthene is substituted with an alkyl group, a phenyl group and a halogen group.
The thioxanthones mean thioxanthone and a derivative in which a part of thioxanthone is substituted with an alkyl group, a phenyl group and a halogen group, and include, for instance, ethylthioxanthone, methylthioxanthone and chlorothioxanthone.
The anthraquinones mean anthraquinone and a derivative in which a part of anthraquinone is substituted with an alkyl group, a phenyl group, a halogen group and the like.

The amount of the hydrogen-abstraction type photopolymerization initiator to be added is preferably 0.3 mass% or more and 10 mass% or less based on the total amount of the photosensitive resin, and more preferably is 0.5 mass% or more and 5 mass% or less.
By setting the amount of the hydrogen-abstraction type photopolymerization initiator to be added within the above described range, the photosensitive resin can sufficiently secure the cured level of the surface of the photo-cured substance when having been photo-cured in the atmosphere, does not cause a crack and the like on the surface of the photo-cured substance when having been stored for a long period, and can secure weather resistance.

The decaying type photopolymerization initiator in the present embodiment is not limited to in particular, but is a compound which causes a cleavage reaction in the molecule after the molecule has absorbed light and produces an active radical.
The decaying type photopolymerization initiator includes, for instance, benzoin alkyl ethers, 2,2-dialkoxy-2-phenylacetophenones, acetophenones, acyloxime esters, azo compounds, organic sulfur compounds, acyl phosphine oxides and diketones.
At least one compound selected from among the decaying type photopolymerization initiators is preferably used as the photopolymerization initiator.
Examples of benzoin alkyl ethers may include benzoin isopropyl ether and benzoin isobutyl ether.
Examples of 2,2-dialkoxy-2-phenylacetophenones may include 2,2-dimethoxy 2-phenylacetophenone and 2,2-diethoxy-2-phenylacetophenone.
Examples of acetophenones may include acetophenone, trichloroacetophenone, 1-hydroxycyclohexyl phenylacetophenone and 2,2-diethoxyacetophenone.
Examples of acyloxime esters may include 1-phenyl-1,2-propanedione-2-(o-benzoyl) oxime.
Examples of the azo compounds may include azobisisobutyronitrile, a diazonium compound and a tetrazene compound.
Examples of diketones may include benzyl and methylbenzoyl formate.
The amount of the decaying type photopolymerization initiator to be added is preferably 0.3 mass% or more and 10 mass% or less based on the total amount of the photosensitive resin, and more preferably is 0.5 mass% or more and 5 mass% or less.
By setting the amount of the decaying type photopolymerization initiator to be added within the above described range, the photosensitive resin can sufficiently secure the cured level of the inner part of the photo-cured substance when having been photo-cured in the atmosphere.

The compound having the site which functions as the hydrogen-abstraction type photopolymerization initiator and the site which functions as the decaying type photopolymerization initiator in the same molecule includes α-aminoacetophenones.
The compound includes, for instance, 2-methyl-1-(4-methyl thiophenyl)-2-morpholino-propane-1-one and 2-benzyl-2-dimethylamino-1-(4-morpholinophenyl)-butanone.

The amount of the compound to be added which has the site that functions as the hydrogen-abstraction type photopolymerization initiator and the site that functions as the decaying type photopolymerization initiator in the same molecule is preferably 0.3 mass% or more and 10 mass% or less based on the total amount of the photosensitive resin, and more preferably is 0.5 mass% or more and 3 mass% or less.
By setting the amount of the compound to be added within the above described range, the photosensitive resin can sufficiently secure the mechanical properties of the photo-cured substance when having been photo-cured in the atmosphere.

In the present embodiment, a polymerization inhibitor, a UV absorber, a dye, a pigment, a lubricant, a surface active agent, a plasticizer, a perfume and the like can be added to the photosensitive resin, according to the application and the purpose.

A method for molding a photosensitive resin into a sheet shape or a cylindrical shape includes an existing method of molding a resin.
The method for molding the photosensitive resin includes, for instance: a casting method; a method of extruding a resin from a nozzle or a dice with the use of a machine such as a pump and an extruder; a method of adjusting the thickness with a blade; a method of adjusting the thickness by calendering the resin with a roll; and a method of spraying the resin with the use of a spray or the like.
When the photosensitive resin is molded, it is also possible to mold the photosensitive resin while heating the photosensitive resin in such a range as not to cause thermal decomposition. When the photosensitive resin is molded, it is also preferable to subject the photosensitive resin to rolling treatment, grinding treatment and the like, as needed.

When the photosensitive resin is molded, the photosensitive resin is generally molded on a sheet-shaped support made from a base material of polyethylene terephthalate, nickel or the like, but can be also directly molded on the cylinder of a printing machine.
In addition, the photosensitive resin can be molded on a cylindrical support such as a plastic sleeve made from a base material of a polyester resin, an epoxy resin or the like, which is reinforced by a fiber including a glass fiber, an aramid fiber, a carbon fiber and the like, and a polyester tube made from a base material of polyethylene terephthalate or the like.
The support in the present embodiment includes a sheet-shaped support, a cylindrical support and a cylinder.

Because the role of the support is to secure the dimensional stability of the cured substance of the photosensitive resin, the support preferably has high dimensional stability.
From the viewpoint of the dimensional stability, a coefficient of linear thermal expansion of the base material for the support is preferably 100 ppm/°C or less, and more preferably is 70 ppm/°C or less.
Specific examples of the base material for the support may include a polyester resin, a polyimide resin, a polyamide resin, a polyamide imide resin, a polyetherimide resin, a polybismaleimide resin, a polysulfone resin, a polycarbonate resin, a polyphenylene ether resin, a polyphenylene thioether resin, a polyether sulfone resin, a liquid crystal resin made from a wholly aromatic polyester resin, a wholly aromatic polyamide resin, and an epoxy resin.
It is also preferable to use a laminate in which these resins are laminated, as the support.

In the uncured-part separation step in the present embodiment, a porous sheet that has adsorbed an uncured part of a photosensitive resin, which has not been cured in an exposure step, is brought into contact with a solvent.
A method for bringing the porous sheet which has adsorbed the uncured part into contact with the solvent is not limited in particular, but when a solvent containing a supercritical fluid is used as the solvent, there is a method of accommodating a porous sheet which has adsorbed the uncured part of the printing face in a high-pressure vessel, and bringing the porous sheet into contact with the supercritical fluid.

The uncured-part separation step is preferably a step of passing the solvent from one surface side of the porous sheet which has adsorbed the uncured part to the other surface side through the inner part of the porous sheet, from the viewpoint of more adequately separating the uncured part and adequately regenerating the porous sheet.
In the present embodiment, a regenerated porous sheet can be produced through the uncured-part separation step.
In the uncured-part separation step, the porous sheet which has adsorbed the uncured part is preferably brought into contact with the solvent in such a form that the porous sheet is wound into the form of a roll, from the viewpoint that the porous sheet can be efficiently regenerated.
In the uncured-part separation step, the uncured part is easily separated from the resin sheet by being brought into contact with the solvent. Accordingly, the regenerated porous sheet can be efficiently produced even though the porous sheet is in the form of being wound into a roll of multilayer structure.

### [Regenerated porous sheet]

The regenerated porous sheet in the present embodiment is a porous sheet produced by bringing a porous sheet which has adsorbed an uncured part into contact with a solvent to separate the uncured part from the porous sheet.
In the present embodiment, the uncured part is sufficiently separated in the uncured-part separation step. Accordingly, the regenerated porous sheet can be used again in a development step.
The porous sheet has been used only once until now, but in the present embodiment, the porous sheet which has been disposed before can be reused, which is preferable in the point of being friendly to the environment.

The regenerated porous sheet according to the present embodiment preferably contains the uncured part having a remaining rate of a resin being less than 50 mass%, from the viewpoint of developing properties of the regenerated sheet. The remaining rate of the resin is preferably less than 30 mass%, and further preferably is less than 10 mass%.
The remaining rate of the resin of the uncured part can be calculated from ([weight of porous sheet after having been regenerated] - [weight of porous sheet]) / ([weight of porous sheet after having been developed] - [weight of porous sheet]) × 100.

The present embodiment also provides a method for regenerating the porous sheet.
A method for regenerating a porous sheet according to the present embodiment comprises:
a step of bringing the porous sheet which has adsorbed an uncured part of a photosensitive resin, into contact with a solvent to separate the uncured part from the porous sheet,
the porous sheet which has adsorbed the uncured part is produced by curing a specific area of the printing surface of a printing original plate in which the printing surface is formed from the photosensitive resin, and then absorbing the uncured part of the printing surface into a porous sheet, so as to conduct a development.
The regenerated porous sheet can be produced by regenerating the porous sheet with the method for regenerating the porous sheet according to the present embodiment.

### [System which regenerates porous sheet and method for recycling porous sheet]

The regenerating system according to the present embodiment comprises: an exposure apparatus for curing a specific area on a printing surface of an original printing plate in which the printing surface is formed from a photosensitive resin; a development apparatus for absorbing the uncured part of the printing surface of the printing original plate into a porous sheet, so as to conduct a development; and an uncured-part separation apparatus for bringing a porous sheet which has adsorbed the uncured part into contact with a solvent, separating the uncured part from the porous sheet, and thereby producing a solution of the separated uncured part and a regenerated porous sheet.

The regenerating system according to the present embodiment preferably further comprises a solvent separation apparatus which separates the solvent from the solution of the separated uncured part to produce the separated uncured part and a separated solvent, from the viewpoint of further decreasing the influence on the global environment.
The solvent separation apparatus can separate the solvent by using differences of a boiling point and a vapor pressure between the solvent and the uncured part, while using a heating and cooling system, a vacuum distillation system or the like such as a distillation tower.
The regenerating system according to the present embodiment preferably further comprises a printing-original-plate forming apparatus which forms a printing original plate with the use of a photosensitive resin that contains the separated uncured part.
The printing-original-plate forming apparatus has a process of introducing a resin of the uncured part added to a process of producing a general photosensitive resin plate by using a kneader or an extruder, for instance, mixes the resin of the uncured part with a general photosensitive resin, and molds the mixture. As for a ratio of mixing the general photosensitive resin with the resin for the uncured part, the resin for the uncured part is preferably less than 20 parts by mass based on 100 parts by mass of the general photosensitive resin, from the viewpoint of stabilizing the photosensitivity and mechanical strength of the printing plate.

In the present embodiment, by using the porous sheet regenerated in the regenerating system again in the development apparatus, the uncured part of the printing surface of the printing original plate can be developed with the regenerated porous sheet.
The regenerating system according to the present embodiment is a recycling system which can recycle a separated uncured part and a separated solvent as a photosensitive resin and a solvent respectively, and accordingly can further decrease the influence on the global environment.
The "system" in the present embodiment means the case of being constituted as an apparatus having a single housing, and also the case in which apparatuses made of respective housings are combined to constitute the whole.

The method for recycling a porous sheet according to the present embodiment is a method of recycling a porous sheet produced by curing a specific area of the printing surface of the printing original plate in which the printing surface is formed from a photosensitive resin, and making the porous sheet adsorb the uncured part to develop the uncured part. The method for recycling the porous sheet according to the present embodiment comprises:
(A) a step of bringing a porous sheet which has adsorbed an uncured part of a photosensitive resin, into contact with a solvent to separate the uncured part from the porous sheet, thereby producing a solution of the separated uncured part and a regenerated porous sheet; and
(B) a step of developing the uncured part of a printing surface by making the porous sheet adsorb the uncured part while using the regenerated porous sheet, after the step (A).
   The method for recycling the porous sheet according to the present embodiment preferably further comprises:
(C) a step of separating a solvent from the solution of the separated uncured part produced in the step (A) to produce the separated uncured part and a separated solvent; and
(D) a step of recycling the separated solvent to be separated in the above described step (C) in the step (A), as the solvent for use in bringing the porous sheet that has adsorbed the uncured part into contact with the solvent, which can further decrease the influence on the global environment.

The method for recycling the porous sheet according to the present embodiment further comprises
(E) a step of forming the printing original plate while using the photosensitive resin containing the separated uncured part that has been separated in the above described step (C),
   which can further decrease the influence on the global environment.

The method for recycling the porous sheet according to the present embodiment can be conducted by using the above described regenerating system.

An uncured-part separation apparatus according to the present embodiment is an uncured-part separation apparatus for separating an uncured part from a porous sheet which has adsorbed the uncured part of the photosensitive resin by bringing the porous sheet into contact with a solvent, and comprises:
a cleaning tank for separating the uncured part from the porous sheet;
a stirring shaft which is arranged in the cleaning tank, holds the porous sheet in a way that the porous sheet is wound, and is rotatable in its circumferential direction; and
a line which supplies the solvent and a line which discharges a solution of a separated uncured part, which contains the separated uncured part that has been separated from the porous sheet,
the porous sheet that has adsorbed the uncured part being produced by curing a specific area of a printing surface of a printing original plate in which the printing surface is formed from a photosensitive resin, and then absorbing the uncured part of the printing surface into a porous sheet, so as to conduct a development.
The uncured-part separation apparatus according to the present embodiment is an apparatus which can be preferably used in a method for producing a regenerated porous sheet according to the present embodiment, the regenerated porous sheet, a method for producing a printing plate, a system which regenerates a porous sheet, and a method for recycling the porous sheet.

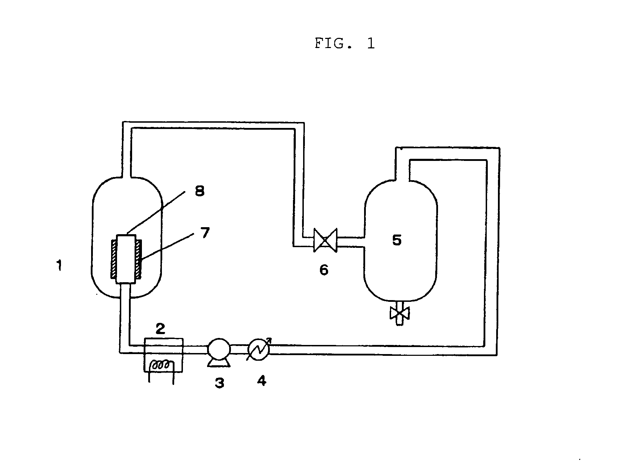

The system which regenerates the porous sheet according to the present embodiment will be described below with reference to Figure 1.
The regenerating system illustrated in Figure 1 illustrates a schematic view of the system which regenerates the porous sheet containing a not-shown exposure apparatus and development apparatus, a high-pressure chamber 1 functioning as an uncured-part separation apparatus, and has a separation tank 5 functioning as a solvent separation apparatus.
The regenerating system comprises: the separation tank 5 which is connected to the high-pressure chamber 1 through a heater 2, a high-pressure pump 3 and a cooler 4 in this order; and an expansion valve 6 which is provided between the separation tank 5 and the high-pressure chamber 1.
The high-pressure chamber 1 has a porous sheet 7 which has adsorbed the uncured part of the photosensitive resin in such a form that the porous sheet is wound into the form of a roll arranged therein, in the state of being wound around a metallic cylinder 8 having a large number of communication holes provided therein.

In development treatment in the development apparatus, the porous sheet is preferably used while being wound off from the roll, from the viewpoint of operation efficiency. The porous sheet which has adsorbed the uncured part of the photosensitive resin is preferably wound up to the roll, also from the viewpoint of the operation efficiency. Accordingly, when the porous sheet is loaded in the high-pressure chamber 1, the porous sheet is preferably treated as in a rolled form (as porous sheet 7 which has been wound in the roll form).

From the viewpoint of adequately treating the porous sheet 7 wound in the roll form in the high-pressure chamber 1, the porous sheet is preferably wound around a cylindrical body (metallic cylinder 8) provided with a large number of holes. The flow path is preferably set so that the solvent passes through this metallic cylinder 8 and passes through the porous sheet from the inner side of the metallic cylinder 8 toward the outer side of the porous sheet 7 which has been wound in the roll form.
The metallic cylinder 8 preferably has a thread cut thereon so as to have a structure of being capable of being fixed at a solvent introduction port in the high-pressure chamber 1 through the thread. The metallic cylinder 8 preferably has such a structure that one end can be covered with a lid and also that the porous sheet 7 wound in the roll is rotatably set in the high-pressure chamber.

In the present embodiment, the porous sheet 7 wound in the roll form is set in the high-pressure chamber 1. Thereafter, the solvent is introduced into the high-pressure chamber 1 from the high-pressure line. When the solvent is introduced therein, the photosensitive resin having deposited on the porous sheet 7 that has been wound in the roll form dissolves in the solvent.

When the supercritical fluid is used as the solvent, the supercritical fluid can be introduced into the high-pressure line of the regenerating system through a high-pressure cylinder.
The pressure of the solvent containing a dissolved photosensitive resin (solution of separated uncured part) is greatly lowered by the expansion valve 6, and the solvent is changed to the gas from the supercritical fluid. At this time, its dissolving power is greatly decreased. As the dissolving power decreases like this, the separated uncured part (photosensitive resin) precipitates from the gas in the separation tank 5, and a separated uncured part and a separated solvent are produced. The separated uncured part accumulates in the separation tank 5.
In the case of the mixture solvent, by setting the temperature of the mixture solvent at a predetermined temperature (approximately 80 degrees), the separated uncured part and the separated solvent can be separated from each other.
On the other hand, a gas of which the pressure has been lowered (separated solvent) is changed to a liquid by a cooler 4, is pressurized by the high-pressure pump 3, is heated by the heater 2, is returned back to the supercritical fluid, and is again introduced into the high-pressure chamber 1. Through the process of repeating steps like these, the photosensitive resin is gradually separated from the porous sheet and the regenerated porous sheet is produced.

By such a series of the treatment, a system is achieved which separates an uncured portion from the porous sheet that contains the uncured part formed from the photosensitive resin and is produced in large quantities in thermal development treatment, and regenerates the porous sheet. In the regenerating system illustrated in Figure 1, the solvent is reintroduced into the high-pressure chamber 1 and is then recycled.
The photosensitive resin which has been accumulated in the separation tank 5 can be blended into a photosensitive resin that is used for a printing surface of a printing original plate, which will be developed in a not-shown development apparatus.
The porous sheet (regenerated porous sheet) which is produced in the high-pressure chamber 1 and from which the above described uncured part has been separated can also be used in the not-shown development apparatus.
An ultimate treatment system which does not emit waste at all is accomplished by such a series of treatments.

It is also possible to treat the porous sheet while drawing the porous sheet with a roll-to-roll form, in the high-pressure chamber 1.

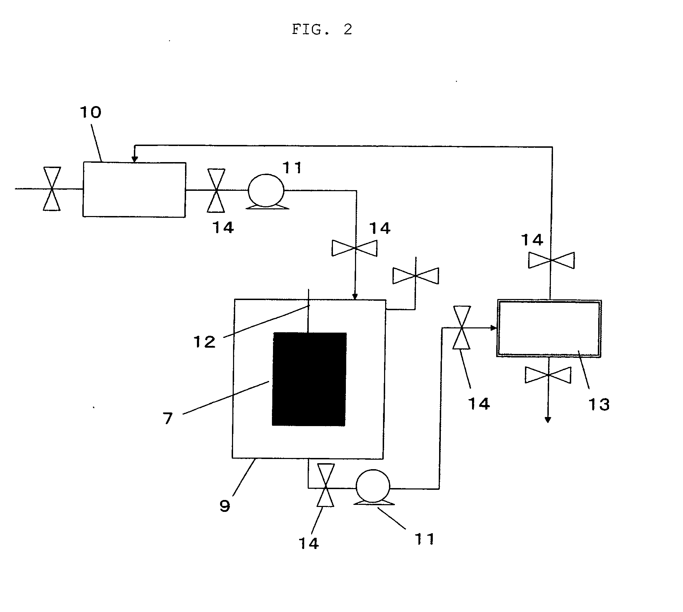

A system which regenerates the porous sheet according to the present embodiment will be described below with reference to Figure 2.
The regeneration system illustrated in Figure 2 comprises a not-shown exposure apparatus and development apparatus, and a cleaning tank 9 functioning as an uncured-part separation apparatus; and is constituted by a pump 11, a heating and cooling tank 13 functioning as the uncured-part separation apparatus, a hydrocarbon-based solvent tank 10 and a pump 11, which are connected in this order with respect to the cleaning tank 9 through a pipeline.
The cleaning tank 9, the heating and cooling tank 13 and the hydrocarbon-based solvent tank 10 are each provided with a depressurizing valve.
In the inner part of the cleaning tank 9, the porous sheet 7 which has adsorbed the uncured part of the photosensitive resin and is wound into the form of a roll is set in the form of being wound around a stirring shaft 12.

In the development treatment in the development apparatus, the porous sheet is preferably used while being wound off from the roll, from the viewpoint of operation efficiency. The porous sheet which has adsorbed the uncured part of the photosensitive resin is preferably wound up to the roll, also from the viewpoint of the operation efficiency. Accordingly, when the porous sheet is loaded in the cleaning tank 9, the porous sheet is preferably treated as in a rolled form (as porous sheet 7 which has been wound in roll form).

From the viewpoint of adequately treating the porous sheet 7 wound in the roll form, the porous sheet is preferably wound around the stirring shaft 12 having a cylindrical body provided with a large number of holes. The flow path is preferably set so that the solvent passes through the inner side of the cylindrical body and passes through the porous body toward the outer side of the porous sheet 7 which has been wound in the roll form. The above described cylindrical body may have the same form as the above described metallic cylinder 8.
The stirring shaft 12 is connected to a rotation control device, and makes the porous sheet 7 wound in the roll form to rotate in its circumferential direction and to be cleaned in the solvent. Thereby, the solvent which has been adsorbed by the porous sheet can be separated from the porous sheet.
It is acceptable to continuously supply the solvent to the cleaning tank 9 from the hydrocarbon-based solvent tank while continuously transporting the solvent to the heating and cooling tank 13 from the cleaning tank 9, or it is also acceptable to close a valve 14 which is directly connected to the cleaning tank 9 to store a certain amount or more of the solvent in the cleaning tank 9 and set the cleaning tank 9 as a closed system, and to clean the resin sheet while rotating the stirring shaft 12.

In the present embodiment, the porous sheet 7 wound in the roll form is set in the cleaning tank 9. Thereafter, the solvent is introduced into the cleaning tank 9 from the hydrocarbon-based solvent tank 10 by the pump 11. When the solvent is introduced therein, the photosensitive resin having deposited on the porous sheet 7 that has been wound in the roll form dissolves in the solvent.
Next, the cleaning solvent which has dissolved the photosensitive resin therein is introduced into the heating and cooling tank 13 with the use of the pump 11. Thereafter, the heating and cooling tank 13 is heated to a predetermined temperature and the valve 14 is opened. Thereby, the solvent is collected in the solvent tank 10, and the separated uncured part is accumulated in the heating and cooling tank 13.
In the cleaning tank 9, the porous sheet is cleaned with the solvent to produce the regenerated porous sheet.

By such a series of the treatment, a system is achieved which separates the uncured portion from the porous sheet that contains the uncured portion formed from a photosensitive resin and is produced in large quantities in thermal development treatment, and regenerates the porous sheet. In the regenerating system illustrated in Figure 2, the separated solvent is reintroduced into the cleaning tank 9 and is then recycled.
The photosensitive resin which has been accumulated in the heating and cooling tank 13 may be in a slurry state of partially containing a solvent, and can be blended into a photosensitive resin that is used for a printing surface of a printing original plate, which is collected as a separated uncured part and will be developed in a not-shown development apparatus.
Furthermore, the porous sheet (regenerated porous sheet) which is produced in the cleaning tank 9 and from which the above described uncured part has been separated can also be used in the not-shown development apparatus.
An ultimate treatment system which does not emit waste at all is completed by such a series of treatments.

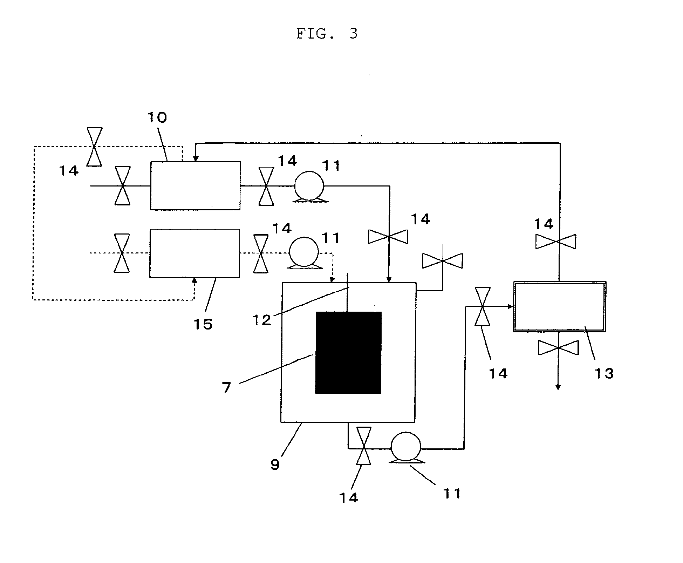

The system which regenerates the porous sheet according to the present embodiment will be described below with reference to Figure 3.
The regeneration system illustrated in Figure 3 comprises a not-shown exposure apparatus and development apparatus, and a cleaning tank 9 functioning as an uncured-part separation apparatus; and is constituted by a pump 14, a heating and cooling tank 13 and a hydrocarbon-based solvent tank 10, which are connected in this order with respect to the cleaning tank 9 through a pipeline. The cleaning tank 9 is constituted by a carbon dioxide tank 15 through a pipeline.
In the inner part of the cleaning tank 9, the porous sheet 7 which has adsorbed the uncured part of the photosensitive resin and is wound into the form of a roll is set in the form of being wound around a stirring shaft 12.

In the present embodiment, the porous sheet 7 wound in the roll form is set in the cleaning tank 9. Thereafter, the hydrocarbon-based solvent functioning as a solvent is introduced into the cleaning tank 9 from the high-pressure pipeline. The hydrocarbon-based solvent tank 10 also communicates with the carbon dioxide tank 15 through the high-pressure pipeline.

In Figure 3, a line which is shown by a solid line that connects the cleaning tank 9, the hydrocarbon-based solvent tank 10 and the heating and cooling tank 13 shows a flow path of a hydrocarbon-based solvent or a mixture solution of a hydrocarbon-based solvent and a supercritical fluid. A line which is shown by a dotted broken line that connects the cleaning tank 9, the hydrocarbon-based solvent tank 10 and the carbon dioxide tank 15 shows a line through which the carbon dioxide is solely supplied.
The solution of the separated uncured part is transported to the heating and cooling tank 13 from the cleaning tank 9. In the heating and cooling tank 13, carbon dioxide is collected at a room temperature, and the hydrocarbon-based solvent is collected by being heated.
The collected carbon dioxide is collected in the carbon dioxide tank through the hydrocarbon-based solvent tank.
The hydrocarbon-based solvent which is separated as a separated solvent in the heating and cooling tank 13 is collected in the hydrocarbon-based solvent 10, and is recycled as a solvent.

### Examples

The present embodiment will be more specifically described below with reference to examples and comparative examples, but the present embodiment is not limited only to these examples. Note that the evaluation method and the measurement method to be used in each of the present embodiments will be described below.

### (Production of photosensitive resin)

A photosensitive resin was obtained by heating 25 parts by mass of an SBS polymer having a number average molecular weight of approximately 100,000 (product with registered trademark of "TUFPRENE A" having softening temperature of approximately 90°C made by Asahi Kasei Chemicals Corporation) as a thermoplastic elastomer, 30 parts by mass of an SBS polymer having a number average molecular weight of approximately 100,000 (product with registered trademark of "TUFPRENE 315" having softening temperature of approximately 90°C made by Asahi Kasei Chemicals Corporation) as a thermoplastic elastomer, 13 parts by mass of 1,9-nonanediol diacrylate (product name "LIGHT-ESTER 1,9ND" made by Kyoeisha Chemical Co., Ltd) as an organic compound, 2 parts by mass of 2,2-dimethoxy-2-phenylacetophenone (product name "IRGACURE651" made by Ciba Japan) as a photopolymerization initiator, 29 parts by mass of liquid polybutadiene (product name "B2000" made by NIPPON OIL CORPORATION) as a plasticizer, and 1 part by mass of 2,6-di-t-butyl acetophenone (product name "Smilizer BHT" made by Sumitomo Chemical Co., Ltd) as a polymerization inhibitor, at 130°C, and mixing them with the use of a kneader (product name "FM-NW3 type" made by POWREX CORPORATION).

### (Production of printing original plate)

A sheet-shaped photosensitive-resin original plate (printing original plate) with the thickness of 1.7 mm was produced by sandwiching the obtained photosensitive resin between a polyester-based film which has the thickness of 188 µm and has an adhesive layer applied on the surface of one side (product name "polyester film U35" made by Toray Industries, Inc.) and a polyester cover film which has the thickness of 25 µm and has the surface release-treated with silicone on one side (product name "DIAFOIL" made by Mitsubishi Polyester Film Corp.), pressurizing in a state of having heated them at 150°C with a hot-pressing machine (made by Toyo Seiki Seisaku-sho, Ltd.). The photosensitive resin layer of the obtained sheet-shaped photosensitive-resin original plate (printing original plate) was solid at 20°C.

### (Exposure treatment)

The sheet-shaped photosensitive-resin original plate was irradiated by ultraviolet rays having the center wavelength of 360 nm emitted from a chemical lamp (product name "RIO" made by ORC MANUFACTURING CO., LTD.) from the cover film side through a mask of a silver salt film (product made by FUJIFILM Corporation) which has a predetermined image pattern formed thereon. Furthermore, the whole support-side surface of the sheet-shaped photosensitive-resin original plate (printing original plate) was irradiated by ultraviolet rays having the center wavelength of 360 nm emitted from a chemical lamp from the base film side as well, and a latent image was formed thereon.

### (Example 1)

The relief depth of 0.5 mm was obtained by: removing a cover film from the sheet-shaped photosensitive resin original plate (exposed printing original plate) on which a latent image was formed; mounting the photosensitive resin original plate on a water-cooling type of cooling drum so that the face of the cover film side could be exposed toward the surface side; heating the photosensitive-resin original plate to approximately 130°C from the surface side with the use of an infrared heater to melt the uncured part; bringing the surface of the photosensitive resin into contact with a non-woven fabric made from polyamide (nylon 6) (product name "CREX2320" made by K.S. Textiles Pty Ltd) having the thickness of 0.35 mm; pressurizing them from above the non-woven fabric with the use of a rubber roll; and thereby making the non-woven fabric side adsorb the uncured photosensitive resin.
The non-woven fabric which had adsorbed the photosensitive resin was charged into a cleaning tank 9 (product name "high-pressure micro reactor" made by OM LAB-TECH CO.,LTD), and toluene (chemicals of reagent grade made by "KANTO CHEMICAL CO.,INC") was supplied from a hydrocarbon-based solvent tank 10 and was introduced into the cleaning tank 9. The non-woven fabric of a porous sheet 7 wound into the form of a roll was cleaned in the cleaning tank 9 at 40°C at the rotation number of 80 rpm for 30 minutes. The cleaning solvent was introduced into the heating and cooling tank 13 and was heated to 80°C. Then, toluene was collected in the hydrocarbon-based solvent tank 10. The weight of the non-woven fabric after having been cleaned was measured, and the rate of the removed resin of the regenerated non-woven fabric to the deposited resin was calculated. As a result, the rate was 98%. The non-woven fabric which was taken out from the cleaning tank 9 could be used again in thermal development treatment. Furthermore, the toluene remaining in the photosensitive resin which accumulated in the heating and cooling tank 13 was distilled away, and 5 mass% of the photosensitive resin was mixed with a new photosensitive resin. Then, the mixture could be used again as a photosensitive resin for producing the photosensitive resin plate.

### (Example 2)

A non-woven fabric was cleaned in the same manner as in Example 1 except that cyclohexane (chemicals of reagent grade made by "KANTO CHEMICAL CO.,INC") was used as a solvent for cleaning. The rate of the removed resin of the regenerated non-woven fabric to the deposited resin was calculated, and as a result, the rate was 90%.

### (Example 3)

A non-woven fabric was cleaned in the same manner as in Example 1 except that chloroform (chemicals of reagent grade made by "KANTO CHEMICAL CO.,INC") was used as an organic solvent for cleaning. The rate of the removed resin of the regenerated non-woven fabric to the deposited resin was calculated, and as a result, the rate was 98%.

### (Example 4)

The non-woven fabric which had adsorbed a photosensitive resin was charged into a cleaning tank 9. Thereafter, toluene was supplied from a hydrocarbon-based solvent tank 10, and carbon dioxide was supplied from a carbon dioxide tank 15 both into the cleaning tank 9.
The molar ratio of the toluene to the carbon dioxide to be contained in the cleaning tank 9 was adjusted to 1 : 4. Furthermore, the toluene and the carbon dioxide were introduced into the cleaning tank 9 so as to be 25 MPa and 40°C and was converted to a supercritical state. Furthermore, the non-woven fabric on which the resin deposited was cleaned in the cleaning tank 9 at 40°C at the rotation number of 80 rpm for 30 minutes. Thereafter, the cleaning solvent was introduced into a heating and cooling tank 13 and carbon dioxide was collected there at a room temperature. Then, the rest was heated to 80°C, and toluene was collected in a solvent tank 10. In addition, the weight of the non-woven fabric after having been cleaned was measured, and the rate of the removed resin to the deposited resin was calculated. As a result, the rate was 97%.

### (Example 5)

A non-woven fabric was cleaned in the same manner as in Example 4 except that the molar ratio of toluene to supercritical carbon dioxide was set at 1 : 9. The rate of the removed resin of the regenerated non-woven fabric to the deposited resin was calculated, and as a result, the rate was 90%.

### (Comparative example 1)

The hot air of 140°C was passed from one side of the non-woven fabric for 1 hour so as to remove the depositing resin, but the removal rate of the depositing resin was 0%.

### (Comparative example 2)

The hot air was passed in the same manner as in Comparative example 1 except that the temperature of the hot air was set at 180°C, but the removal rate of the depositing resin was 0%.

This application is based on Japanese patent application (Japanese Patent Application No. 2007-322325) which was filed on December 13, 2007, which is hereby incorporated by reference herein.

### Industrial applicability

The method for producing the regenerated porous sheet according to the present invention comprises separating the photosensitive resin from a porous sheet which contains the photosensitive resin and is produced in large quantities in the thermal development treatment to be used when a photosensitive-resin relief printing plate is produced by using a photoengraving technology, thereby can regenerate the porous sheet, and accordingly has industrial applicability in a field of a printing technology.

## Claims

1. A method for producing a regenerated porous sheet comprising
a step of bringing a porous sheet which has adsorbed an uncured part of a photosensitive resin, into contact with a solvent to separate the uncured part from the porous sheet,
the porous sheet that has adsorbed uncured part being produced by curing a specific area of a printing surface of a printing original plate in which the printing surface is formed from the photosensitive resin, and then absorbing the uncured part of the printing plate into a porous sheet, so as to conduct a development.

2. The method according to Claim 1, wherein the developing is thermal development.

3. The method according to Claim 1 or 2, wherein
the step of bringing of the porous sheet into contact with the solvent is performed in a way that the solvent is passed from one surface side of the porous sheet to the other surface side through the inner part of the porous sheet.

4. The method according to any one of Claims 1 to 3, wherein the step of bringing of the porous sheet into contact with the solvent is performed in a way that the porous sheet is wound into the form of a roll.

5. The method according to Claim 4, wherein the porous sheet is in a form of being wound into the form of a roll of multilayer structure.

6. The method according to any one of Claims 1 to 5, wherein the melting temperature of the photosensitive resin is 80°C or more and 200°C or less, and the photosensitive resin is solid at a temperature of 20°C.

7. The method according to any one of Claims 1 to 6, wherein the photosensitive resin contains a thermoplastic elastomer which has a number average molecular weight of 50,000 or more and 500,000 or less, and an organic compound which has a number average molecular weight of less than 50,000 and has a polymerizable unsaturated group in the molecule.

8. The method according to Claim 6 or 7, wherein the thermoplastic elastomer is a styrenic elastomer.

9. The method according to any one of Claims 1 to 8, wherein the solvent comprises at least one selected from the group consisting of an aromatic hydrocarbon, an alicyclic hydrocarbon, a straight-chain hydrocarbon, a branched hydrocarbon and a halogenated hydrocarbon.

10. The method according to any one of Claims 1 to 9, wherein the solvent comprises a supercritical fluid.

11. The method according to Claim 10, wherein the supercritical fluid is supercritical carbon dioxide.

12. The method according to Claim 10 or 11, wherein a critical point of the supercritical fluid exists in a temperature range of 25°C or more and 80°C or less and in a pressure range of 3 MPa or more and 100 MPa or less.

13. The method according to any one of Claims 1 to 12, wherein the porous sheet is comprised of a fibrous material.

14. The method according to any one of Claims 1 to 13, wherein the porous sheet comprises at least one selected from the group consisting of polyester, polyolefin, polyurethane, polyamide and cellulose, as a main component.

15. The method according to any one of Claims 1 to 14, wherein the porous sheet is a woven fabric or a non-woven fabric.

16. A regenerated porous sheet obtained by the method according to any one of Claims 1 to 15.

17. A method for producing a printing plate in which a printing surface is formed from a photosensitive resin, comprising a step of developing with a use of the regenerated porous sheet according to Claim 16.

18. A system for regenerating a porous sheet, comprising:
an exposure apparatus which cures a specific area of a printing surface of a printing original plate in which the printing surface is formed from a photosensitive resin;
a development apparatus which absorbs an uncured part of the printing surface of the printing original plate into a porous sheet, so as to conduct a development; and
an uncured-part separation apparatus which brings the porous sheet which has adsorbed the uncured part, into contact with a solvent to separate the uncured part from the porous sheet, thereby producing a solution of the separated uncured part and a regenerated porous sheet.

19. The system according to Claim 18, wherein the regenerated porous sheet is used in the development apparatus.

20. The system according to Claim 18 or 19, further comprising a solvent separation apparatus which separates a solvent from the solution of the separated uncured part to produce the separated uncured part and a separated solvent.

21. The system according to Claim 20, wherein the separated solvent is used in the uncured-part separation apparatus.

22. The system according to Claim 20 or 21, further comprising a printing-original-plate forming apparatus which forms the printing original plate while using a photosensitive resin containing the separated uncured part.

23. A method for recycling a porous sheet, comprising:
(A) a step of bringing a porous sheet which has adsorbed an uncured part of a photosensitive resin, into contact with a solvent to separate the uncured part from the porous sheet, thereby producing a solution of the separated uncured part and a regenerated porous sheet; and
(B) a step of absorbing the uncured part of a printing surface into a porous sheet while using the regenerated porous sheet, after the step (A),
the porous sheet that has adsorbed the uncured part being produced by curing a specific area of a printing surface of a printing original plate in which the printing surface is formed from the photosensitive resin, and then absorbing the uncured part of the printing plate into a porous sheet, so as to conduct a development.

24. The method according to Claim 23, further comprising (C) a step of separating the solvent from the solution of the separated uncured part to produce the separated uncured part and a separated solvent.

25. The method according to Claim 24, further comprising (D) a step of bringing the porous sheet which has adsorbed the uncured part, into contact with the solvent while using the separated solvent as the solvent.

26. The method according to Claim 24 or 25, further comprising (E) a step of forming the printing original plate while using the photosensitive resin containing the separated uncured part.

27. An uncured-part separation apparatus which brings a porous sheet which has adsorbed an uncured part of a photosensitive resin, into contact with a solvent to separate the uncured part from the porous sheet, comprising:
a cleaning tank for separating the uncured part from the porous sheet;
a stirring shaft which is arranged in the cleaning tank, and which holds the porous sheet in a way that the porous sheet is wound, and is rotatable in a circumferential direction thereof; and
a line which supplies the solvent and a line which discharges a solution of a separated uncured part, which contains the separated uncured part that has been separated from the porous sheet,
the porous sheet that has adsorbed the uncured part being produced by curing a specific area of a printing surface of a printing original plate in which the printing surface is formed from a photosensitive resin, and then absorbing the uncured part of the printing surface into a porous sheet, so as to conduct a development.
